# EUROPEAN PATENT APPLICATION

(11) **EP 2 383 782 A2**
(43) Date of publication of application: **02.11.2011**
(21) Application number: 11164229.4
(22) Date of filing: 29.04.2011
(51) Int. Cl.: H01L 27/142

(54) **See-through solar battery module and manufacturing method thereof**

(30) Priority: 30.04.2010 TW 099113789
(71) Applicant: Axuntek Solar Energy, Pingtung County 900 (TW)
(72) Inventor: Lee, Shih-Wei, 843, Kaohsiung City (TW); Lin, Ching-Ju, Fengshan Dist., Kaohsiung City 830 (TW); Huang, Wei-Min, 116, Taipei City (TW); Hou, Chi-Hung, 100, Taipei City (TW); Chen, Yen-Chun, 330, Taoyuan County (TW)
(74) Representative: Becker, Eberhard

(57) **Abstract**

A see-through solar battery module (20, 42, 52) includes a transparent substrate (22), a plurality of striped metal electrodes (24) formed on the transparent substrate (22) along a first direction, a plurality of striped photoelectric transducing layers (26) respectively formed on the corresponding striped metal electrodes (24) and the transparent substrate (22) along the first direction, and a plurality of striped transparent electrodes (28) respectively formed on the transparent substrate (22), the corresponding striped metal electrodes (24), and the corresponding striped photoelectric transducing layers (26) along the first direction, so that the plurality of striped metal electrodes (24) and the plurality of striped transparent electrodes (28) are in series connection along a second direction different from the first direction. A side of each striped photoelectric transducing layer (26) is formed on the transparent substrate (22) and does not contact the adjacent striped metal electrode (24).

## Description

### Field of the Invention

The present invention relates to a see-through solar battery module and a related manufacturing method according to the pre-characterizing clause of claims 1 and 8.

### Background of the Invention

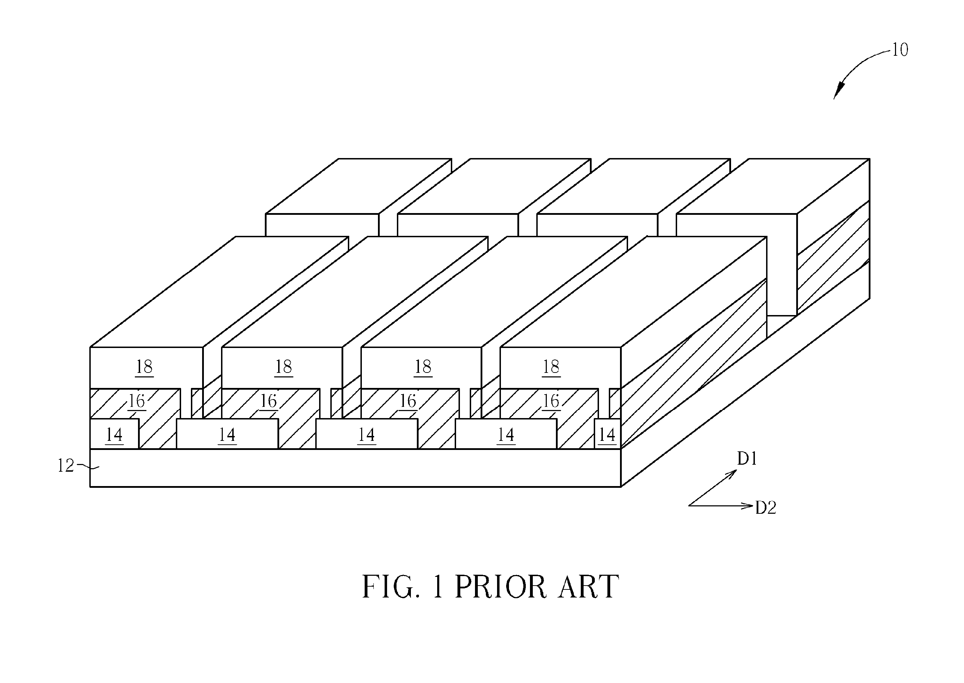

Generally, the conventional solar batteries are classified as the see-through solar battery and the non see-through solar battery. The non see-through solar battery is widely applied on building material, such as on a tile structure, a hanging, and so on. On the other hand, the see-through solar battery is applied on the other specific ways for preferable aesthetic appearance, such as a transparent wall, a transparent roof, and so on. Please refer to FIG.1. FIG.1 is a conventional see-through solar battery module 10 in the prior art. The see-through solar battery module 10 includes a transparent substrate 12, a transparent conductive layer 14, a photoelectric transducing layer 16, and an opaque electrode 18. The method of manufacturing the see-through solar battery module 10 is directly removing parts of the opaque electrode 18 and parts of the photoelectric transducing layer 16 to expose parts of the transparent substrate 12 and parts of the transparent conductive layer 14 for transmitting a beam to pass through the see-through solar battery module 10. However, the photoelectric transducing efficiency of the see-through solar battery module 10 is decreased as the parts of the photoelectric transducing layer 16 are removed. Thus, design of a see-through battery module having preferable photoelectric transducing efficiency is an important issue of the solar industry.

### Summary of the Invention

This in mind, the present invention aims at providing a see-through solar battery module and a related manufacturing method of high photoelectric transducing efficiency, high production yield, and low manufacturing cost.

This is achieved by a see-through solar battery module and a related manufacturing method according to claims 1 and 8. The dependent claims pertain to corresponding further developments and improvements.

As will be seen more clearly from the detailed description following below, the claimed see-through solar battery module includes a transparent substrate, a plurality of striped metal electrodes, a plurality of striped photoelectric transducing layers and a plurality of striped transparent electrodes.

According to an embodiment, a see-through solar battery module includes a transparent substrate, a plurality of striped metal electrodes formed on the transparent substrate along a first direction, and a plurality of striped photoelectric transducing layers respectively formed on the corresponding striped metal electrodes and the transparent substrate along the first direction. A side of each striped photoelectric transducing layer is formed on the transparent substrate and not contacting the adjacent striped metal electrode. The see-through solar battery module further includes a plurality of striped transparent electrodes respectively formed on the transparent substrate, the corresponding striped metal electrodes, and the corresponding striped photoelectric transducing layers along the first direction, so that the plurality of striped metal electrodes and the plurality of striped transparent electrodes are in series connection along a second direction different from the first direction.

According to another embodiment, each striped metal electrode does not contact the adjacent striped metal electrode along the first direction, each striped photoelectric transducing layer does not contact the transparent substrate and the adjacent striped photoelectric transducing layer along the first direction, and each striped transparent electrode does not contact the transparent substrate, the corresponding striped metal electrode, and the adjacent striped transparent electrode along the first direction.

According to another embodiment, each striped metal electrode does not contact the adjacent striped metal electrode along the first direction, each striped photoelectric transducing layer does not contact the adjacent striped photoelectric transducing layer along the first direction, and each striped transparent electrode does not contact the corresponding striped metal electrode along the first direction.

According to another embodiment, a buffer could be formed between the striped photoelectric transducing layer and the striped transparent electrode. The buffer is made of zinc sulphide (ZnS) material and intrinsic zinc oxide (ZnO) material.

According to another embodiment, the striped photoelectric transducing layer is made of copper indium gallium selenide (CIGS) material.

According to another embodiment, the striped transparent electrode is a transparent conductive layer made of aluminum zinc oxide (AZO) or tin-doped indium oxide (ITO) material.

According to an embodiment, a method of manufacturing a see-through solar battery module includes forming a metal electrode on a transparent substrate, removing parts of the metal electrode along a first direction to form a plurality of striped metal electrodes arranged in parallel, forming a photoelectric transducing layer on the plurality of striped metal electrodes and the transparent substrate, removing parts of the photoelectric transducing layer along the first direction to form a plurality of striped photoelectric transducing layers arranged in parallel so as to expose parts of the transparent substrate and parts of the plurality of striped metal electrode, forming a transparent electrode on the transparent substrate, the plurality of striped metal electrodes, and the plurality of striped photoelectric transducing layers, and removing parts of the transparent electrode along the first direction to form a plurality of striped transparent electrodes arranged in parallel, so that the plurality of striped metal electrodes and the plurality of striped transparent electrodes are in series connection along a second direction different from the first direction.

According to another embodiment, the method further includes removing the parts of the striped transparent electrode, the parts of the striped photoelectric transducing layer, and the parts of the striped metal electrode along the second direction so as to expose parts of the transparent substrate.

According to another embodiment, the method further includes removing parts of the plurality of striped metal electrodes along the second direction to form the plurality of block metal electrodes arranged as an array after removing the parts of the metal electrode along the first direction to form the plurality of striped metal electrodes arranged in parallel, and removing parts of the plurality of striped photoelectric transducing layers along the second direction to expose parts of the transparent substrate after removing the parts of the photoelectric transducing layer along the first direction to form the plurality of striped photoelectric transducing layers arranged in parallel.

According to another embodiment, removing the parts of the transparent electrode along the first direction comprises removing the parts of the transparent electrode and the parts of the photoelectric transducing layer along the first direction simultaneously.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof
FIG.1 is the conventional see-through solar battery module in the prior art,
FIG.2 is a diagram of the see-through solar battery module according to a preferred embodiment of the invention,
FIG.3 is a flow chart of the method of manufacturing the see-through solar battery module according to the preferred embodiment of the invention,
FIG.4 to FIG.11 are sectional views of the see-through solar battery module along the second direction in different procedures according to the preferred embodiment of the invention,
FIG.12 is a diagram of the projecting device according to an embodiment of the invention, and
FIG.13 is a diagram of the projecting device according to another embodiment of the invention.

### Detailed Description

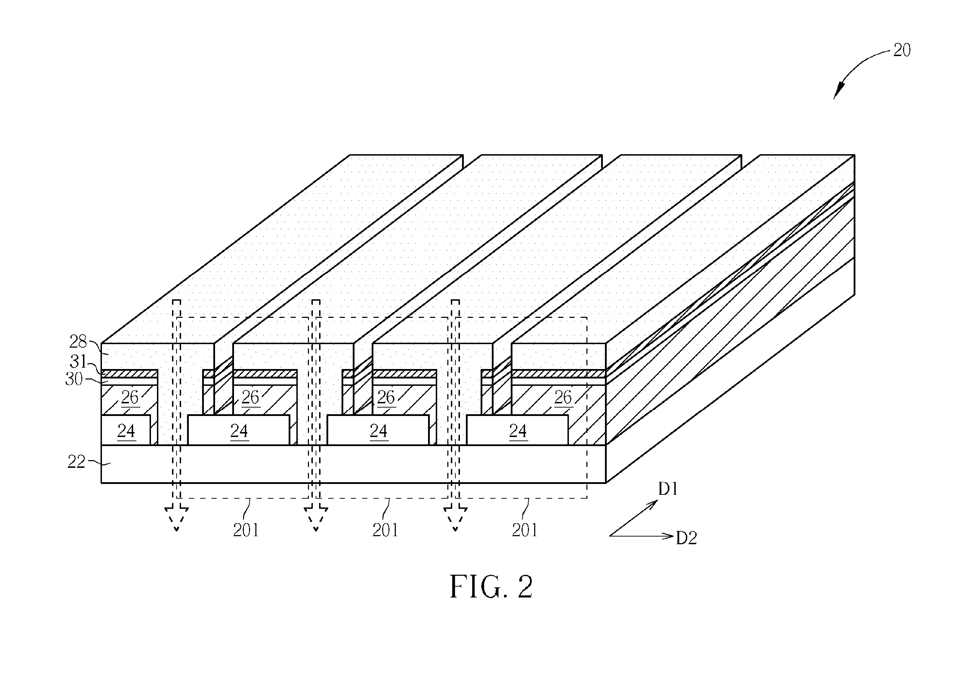

Please refer to FIG.2. FIG.2 is a diagram of a see-through solar battery module 20 according to a preferred embodiment of the invention. The see-through solar battery module 20 includes a transparent substrate 22, a plurality of striped metal electrodes 24 formed on the transparent substrate 22 along a first direction D1, and a plurality of striped photoelectric transducing layers 26 respectively formed on the corresponding striped metal electrodes 24 and the transparent substrate 22 along the first direction D1. As shown in FIG.2, a side of each striped photoelectric transducing layer 26 is formed on the transparent substrate 22 and does not contact the adjacent striped metal electrode 24, so that parts of the transparent substrate 22 is exposed between the adjacent striped photoelectric transducing layers 26 and the adjacent striped metal electrodes 24. The see-through solar battery module 20 further includes a plurality of striped transparent electrodes 28 formed on the transparent substrate 22, the corresponding striped metal electrode 24, and the corresponding striped photoelectric transducing layer 26 along the first direction D1. The see-through solar battery module 20 could be consisted of a plurality of solar batteries 201. The photoelectric transducing layer 26 transforms solar energy into electric power, and the metal electrode 24 and the transparent electrode 28 are a positive electrode and a negative electrode of the solar battery 201 for outputting the electric power respectively. Therefore, the plurality of striped metal electrodes 24 are electrically connected to the plurality of striped transparent electrodes 28 along a second direction D2 different from the first direction D1, which means the plurality of solar batteries 201 are in series connection along the second direction D2, so that an outputting voltage of the see-through solar battery module 20 could be adjusted according to actual demand. In addition, the see-through solar battery module 20 could further include buffers 30, 31 disposed between the striped photoelectric transducing layer 26 and the striped transparent electrode 28.

Generally, the transparent substrate 22 could be made of soda-lime glass, the striped metal electrode 24 could be made of molybdenum (Mo) material, the striped photoelectric transducing layer 26 could be made of copper indium gallium selenide (CIGS) material, the striped transparent electrode 28 could be made of aluminum zinc oxide (AZO) or tin-doped indium oxide (ITO) material, and the buffers 30, 31 could be respectively made of zinc sulphide (ZnS) material and intrinsic zinc oxide (ZnO) material. Material of the transparent substrate 22, the striped metal electrode 24, the striped photoelectric transducing 26, the striped transparent electrode 28, and the buffers 30, 31 are not limited to the above-mentioned embodiment, and depend on design demand. Due to the transparent property of the soda-lime glass, AZO (or ITO), and the intrinsic ZnO, beams could pass through areas of the see-through solar battery module 20 (shown as arrows in FIG.2), and a user could view the scene through the see-through solar battery module 20.

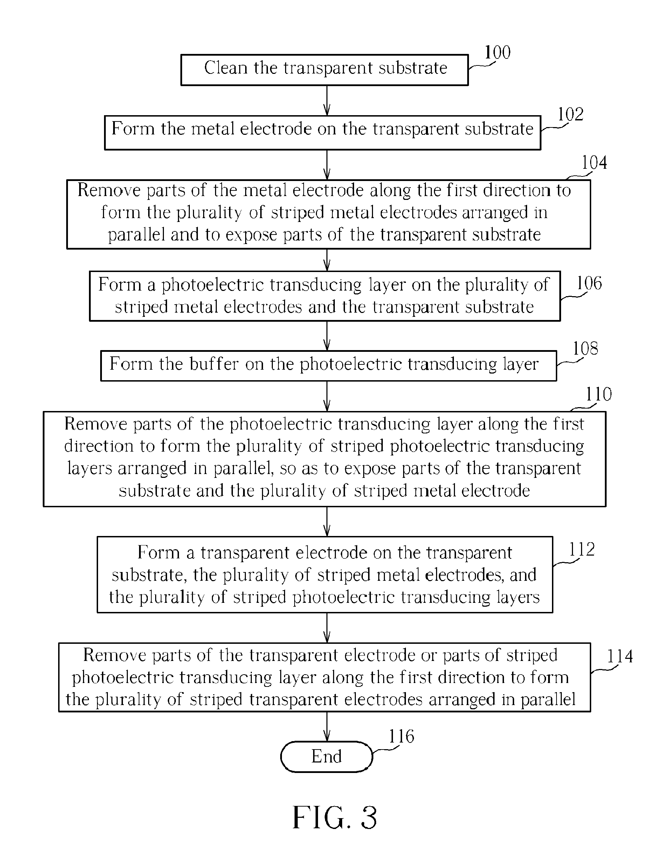

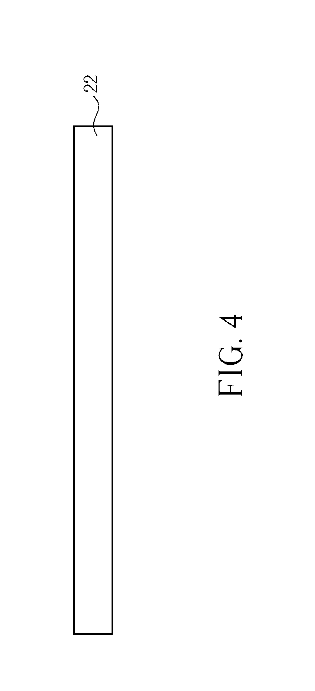

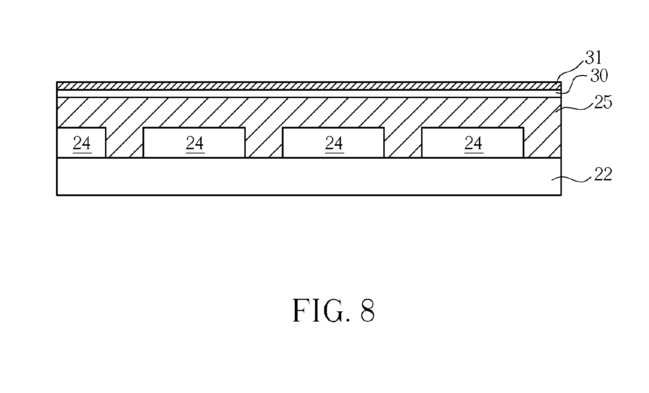

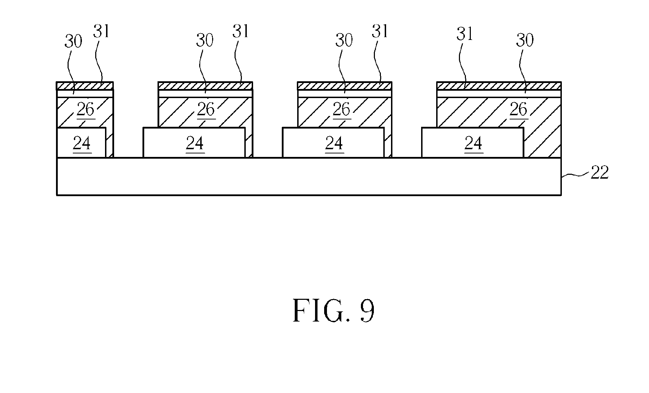

Please refer to FIG.2 and FIG.3 to FIG.11. FIG.3 is a flow chart of the method of manufacturing the see-through solar battery module 20 according to the preferred embodiment of the invention. FIG.4 to FIG.11 are sectional views of the see-through solar battery module 20 along the second direction D2 in different procedures according to the preferred embodiment of the invention. The method includes following steps:
Step 100: Clean the transparent substrate 22;
Step 102: Form a metal electrode 23 on the transparent substrate 22;
Step 104: Remove parts of the metal electrode 23 along the first direction D1 to form the plurality of striped metal electrodes 24 arranged in parallel and to expose parts of the transparent substrate 22;
Step 106: Form a photoelectric transducing layer 25 on the plurality of metal electrodes 24 and the transparent substrate 22;
Step 108: Form the buffer 30 made of the ZnS material and the buffer 31 made of the intrinsic ZnO material on the photoelectric transducing layer 25;
Step 110: Remove parts of the photoelectric transducing layer 25 and parts of the buffers 30, 31 along the first direction D1 to form the plurality of striped photoelectric transducing layers 26 arranged in parallel, so as to expose the parts of the transparent substrate 22 and parts of the plurality of striped metal electrodes 24;
Step 112: Form a transparent electrode 27 on the transparent substrate 22, the plurality of striped metal electrodes 24, and the plurality of striped photoelectric transducing layers 26;
Step 114: Remove parts of the transparent electrode 27 and the parts of striped photoelectric transducing layer 26 along the first direction D1 simultaneously to form the plurality of striped transparent electrodes 28 arranged in parallel, so that the striped metal electrode 24 and the striped transparent electrode 28 of each solar battery 201 are in series connection along the second direction D2; and
Step 116: The end.

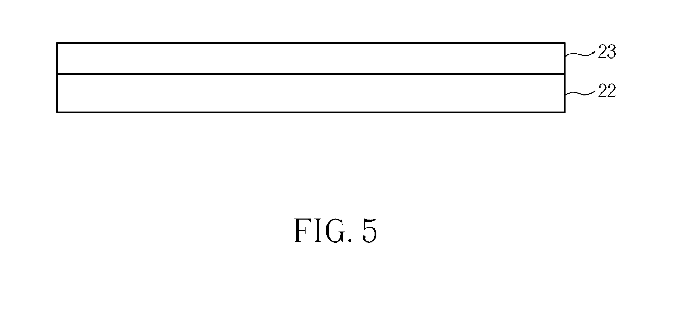

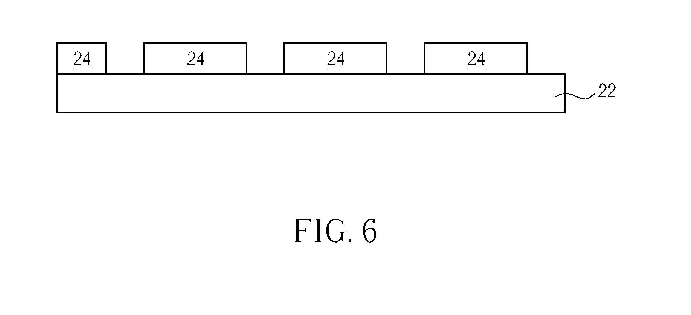

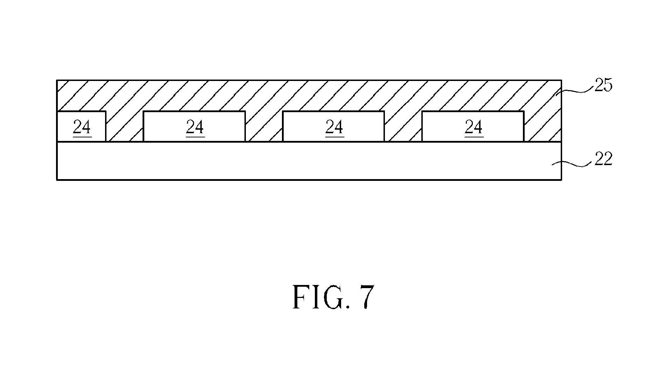

Detailed description of the above-mentioned method is introduced as follows, and step 100 to step 114 corresponds to FIG.4 to FIG.11 respectively. As shown in FIG.4, the transparent substrate 22 is cleaned for preventing dirt from heaping on the transparent substrate 22. At this time, a blocking layer made of Al2O3 or Si02 material could be selectively formed on the transparent substrate 22 for blocking the current from passing. Further, NaF material could be formed on the transparent substrate 22 by evaporation for crystallizing the CIGS material on the transparent substrate 22. Then, as shown in FIG.5 and FIG.6, the metal electrode 23 made of the Mo material could be formed on the transparent substrate 22 by a sputter, and the parts of the metal electrode 23 could be removed along the first direction D1 by laser technology or other removing technology, so as to expose the parts of the transparent substrate 22 and to form the plurality of striped metal electrodes 24 arranged in parallel. As shown in FIG.7 to FIG.9, the photoelectric transducing layer 25 could be formed on the plurality of striped metal electrodes 24 and the exposed transparent substrate 22 by thin film deposition, the buffer 30 made of the ZnS material and the buffer 31 made of the intrinsic ZnO material could be formed on the photoelectric transducing layer 25, and the parts of the photoelectric transducing layer 25 and the parts of the buffers 30, 31 could be removed along the first direction D1 by a scraper or other removing method, so as to form the plurality of striped photoelectric transducing layers 26 arranged in parallel and to expose the parts of the transparent substrate 22 and the parts of the striped metal electrode 24. The intrinsic ZnO material is a transparent film having preferable photoelectric property for increasing the photoelectric transducing efficiency and the electricity generating efficiency of the see-through solar battery module 20. Generally, the thin film deposition could utilize co-evaporation, vacuum sputter, and selenization to achieve preferable photoelectric transducing efficiency of the CIGS film.

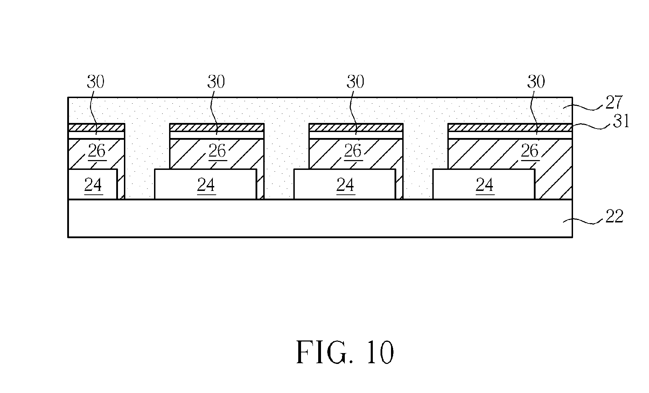

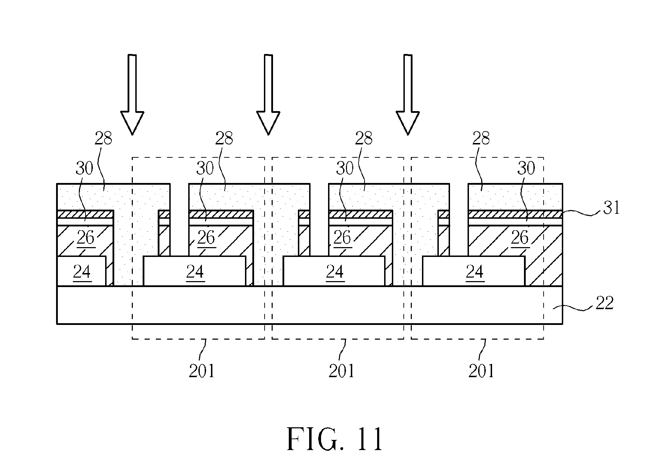

Finally, as shown in FIG.10 and FIG.11, the transparent electrode 27 is formed on the buffer 31, and then parts of the transparent electrode 27 and the parts of the striped photoelectric transducing layer 26 are removed along the first direction D1 simultaneously, so as to form the plurality of striped transparent electrodes 28 arranged in parallel. Thus, the see-through solar battery module 20 could include the plurality of solar batteries 201, and the striped metal electrode 24 and the striped transparent electrode 28 of the solar batteries 201 are in series connection along the second direction D2, so that the beams could pass through the solar batteries 201 via the areas where the striped transparent electrode 28 contacts the transparent substrate 22 (shown as the arrows in FIG.11). Material and manufacturing procedures of the buffers 30, 31 are not limited to the above-mentioned embodiment, which is a selectable procedure, and it depends on design demand.

The see-through solar battery module 20 of the invention redesigns the conventional procedures for light transmission. The invention could not remove the photoelectric transducing layer 26 additionally, so that the see-through solar battery module 20 could include the photoelectric transducing layer 26 with large dimension, which results in preferable photoelectric transducing efficiency. Due to the transparent areas located between the adjacent solar batteries 201 of the see-through solar battery module 20, the illumination fringes are parallel to a direction of the solar battery 201. However, the illumination fringes of the see-through solar battery module 20 are not limited to the direction of the solar battery 201, for example, the illumination fringes could be formed as dotted patterns. Thus, the dotted patterns could be arranged to form a symbol or a character for increasing practicability of the invention.

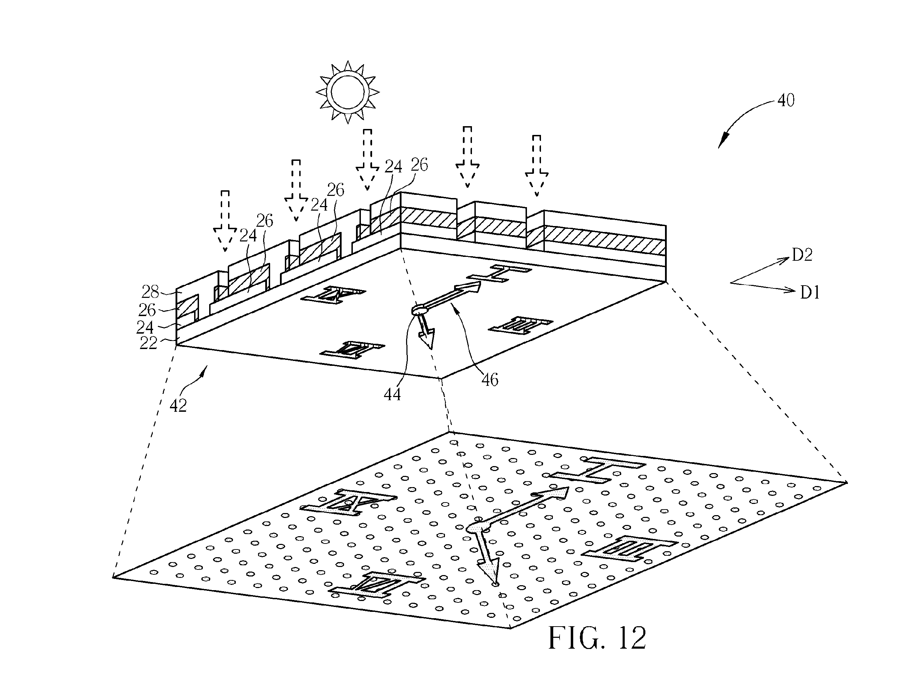

Please refer to FIG.12. FIG.12 is a diagram of a projecting device 40 according to an embodiment of the invention. The projecting device 40 includes a see-through solar battery module 42, a motor 44 disposed on a bottom of the see-through solar battery module 42, and a pointer 46 disposed on the motor 44. Functions and disposal of components of the see-through solar battery module 42 are the same as ones of the see-through solar battery module 20, and the detailed description is omitted herein for simplicity. For manufacturing the see-through solar battery module 42, parts of the striped metal electrode 24, parts of the photoelectric transducing layer 26, and parts of the striped transparent electrode 28 could be removed along the second direction D2 after the above-mentioned manufacturing method so as to expose parts of the transparent substrate 22. That is to say, the manufacturing method of the see-through solar battery module 42 along the first direction D1 is forming the plurality of striped metal electrodes 24 on the transparent substrate 22, wherein each striped metal electrode 24 does not contact the adjacent striped metal electrode 24 along the first direction D1, forming the plurality of striped photoelectric transducing layers 26 on the corresponding striped metal electrodes 24 respectively, wherein each striped photoelectric transducing layer 26 does not contact the adjacent striped photoelectric transducing layer 26 along the first direction D1, and forming the plurality of striped transparent electrode 28 on the corresponding striped photoelectric transducing layers 26 respectively, wherein each striped transparent electrode 28 does not contact the transparent substrate 22, the corresponding striped metal electrode 24, and the adjacent striped transparent electrode 28 along the first direction D1. As shown in FIG.12, the transparent areas with the dotted patterns could be formed on the see-through solar battery module 42 according to the above-mentioned method, so as to transmit the beams through the see-through solar battery module 42 along the arrow direction. In addition, the dotted patterns could be utilized to form different symbols, such as a numeral. When the projecting device 40 projects the image of the numeral on a projecting curtain, and the pointer 46 is rotated regularly for moving its shadow to point the projecting images of different numerals, the projecting device 40 could be a dynamic projecting pointer, such as a clock. Furthermore, the see-through solar battery module 42 could supply power to the motor 44 for driving the pointer 46, so that the projecting device 40 could be a solar clock. Besides, the pointer 46 could be set on the projecting curtain, and the protecting device 40 could project the images of different numerals on the projecting curtain, so as to form a clock-typed print. In conclusion, the invention could design the see-through solar battery module to project the images with different patterns, such as the symbol or the character, so that the invention has preferable photoelectric transducing efficiency and wonderful aesthetic appearance.

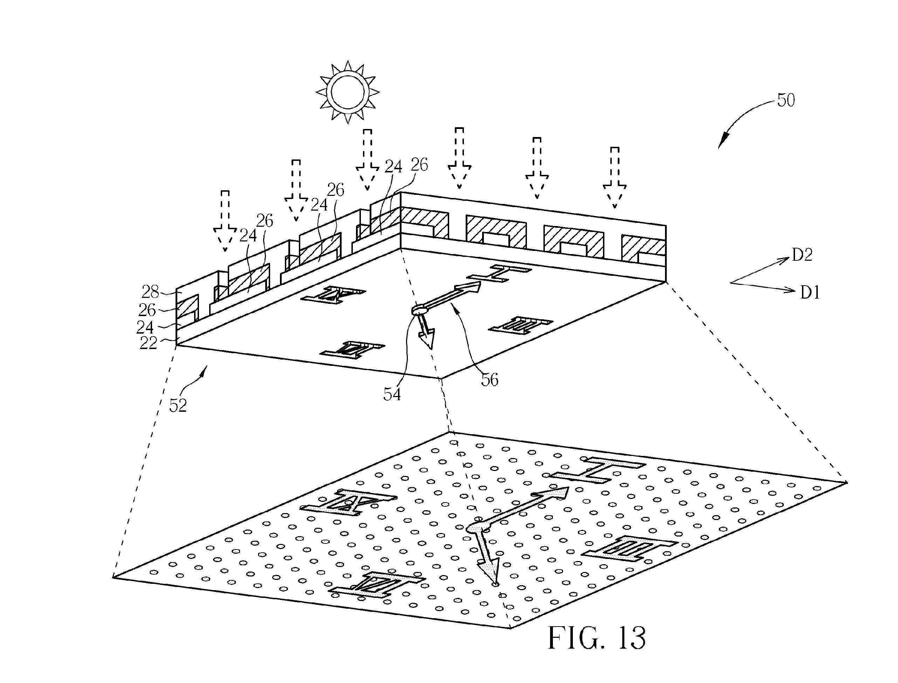

Please refer to FIG.13. FIG.13 is a diagram of a projecting device 50 according to another embodiment of the invention. The projecting device 50 includes a see-through solar battery module 52, a motor 54 disposed on a bottom of the see-through solar battery module 52, and a pointer 56 disposed on the motor 54. Functions and disposal of components of the see-through solar battery module 52 are the same as the ones of the above-mentioned see-through solar battery module 20, and the detailed description is omitted herein for simplicity. In order to project the image with the dotted patterns by the see-through solar battery module 52, parts of the metal electrode 23 could be removed along the first direction D1 and the second direction D2 to form the plurality of block metal electrodes 24 arranged as an array, and parts of photoelectric transducing layer 25 could be removed along the first direction D1 to form the plurality of striped photoelectric transducing layers 26 arranged in parallel. Finally, parts of the plurality of striped photoelectric transducing layers 26 could be removed along the second direction D2 so as to expose the parts of the transparent substrate 22. On the other words, the see-through solar battery module 52 includes the plurality of striped metal electrodes 24 formed on the transparent substrate 22 wherein each the striped metal electrode 24 does not contact the adjacent striped metal electrode 24 along the first direction D1, the plurality of striped photoelectric transducing layers 26 respectively formed on the corresponding striped metal electrode 24 and the transparent substrate 22 wherein each the striped photoelectric transducing layer 26 does not contact the adjacent striped photoelectric transducing layer 26 along the first direction D1, and the plurality of striped transparent electrodes 28 respectively formed on the corresponding striped photoelectric transducing layer 26 and the transparent substrate 22 wherein each the striped transparent electrode 28 does not contact the corresponding striped metal electrode 24 along the first direction D1. Thus, as shown in FIG.13, the transparent areas with the dotted patterns could be formed on the see-through solar battery module 52 at any directions for transmitting the beams along the arrow direction according to the above-mentioned method. In addition, the dotted patterns could be utilized to form different symbols, such as a numeral. As the above-mentioned embodiment, when the projecting device 50 projects the numeral images on the projecting curtain, and the pointer 56 is rotated regularly for moving its shadow to point the projecting images with different numerals, the projecting device 50 could be a dynamic projecting pointer, such as a clock. As the see-through solar battery module 52 supplies power to the motor 54 for driving the pointer 56, the projecting device 40 could be a solar clock. Besides, the pointer 56 could be set on the projecting curtain, and the protecting device 50 could project the images with different numerals on the projecting curtain, so as to form a clock-typed print.

Comparing to the prior art, the invention forms the transparent areas on the see-through solar battery module by redesigning the conventional manufacturing method. The method of the invention has simple procedures and does not remove additional photoelectric transducing layer, so that the invention has advantages of high photoelectric transducing efficiency, high production yield, and low manufacturing cost. In addition, the invention could form the projecting image with varies patterns, such as the symbol or the character, for increasing the practicability of the see-through solar battery module.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A see-through solar battery module (20, 42, 52) comprising:
a transparent substrate (22);
**characterized by**:
a plurality of striped metal electrodes (24) formed on the transparent substrate (22) along a first direction;
a plurality of striped photoelectric transducing layers (26) respectively formed on the corresponding striped metal electrodes (24) and the transparent substrate (22) along the first direction, a side of each striped photoelectric transducing layer (26) being formed on the transparent substrate (22) and not contacting the adjacent striped metal electrode (24); and
a plurality of striped transparent electrodes (28) respectively formed on the transparent substrate (22), the corresponding striped metal electrodes (24), and the corresponding striped photoelectric transducing layers (26) along the first direction so that the plurality of striped metal electrodes (24) and the plurality of striped transparent electrodes (28) are in series connection along a second direction different from the first direction.

2. The see-through solar battery module (20, 42, 52) of claim 1, further **characterized in that** each striped metal electrode (24) does not contact the adjacent striped metal electrode (24) along the first direction, each striped photoelectric transducing layer (26) does not contact the transparent substrate (22) and the adjacent striped photoelectric transducing layer (26) along the first direction, and each striped transparent electrode (28) does not contact the transparent substrate (22), the corresponding striped metal electrode (24), and the adjacent striped transparent electrode (28) along the first direction.

3. The see-through solar battery module (20, 42, 52) of claim 1, further **characterized in that** each striped metal electrode (24) does not contact the adjacent striped metal electrode (24) along the first direction, each striped photoelectric transducing layer (26) does not contact the adjacent striped photoelectric transducing layer (26) along the first direction, and each striped transparent electrode (28) does not contact the corresponding striped metal electrode (24) along the first direction.

4. The see-through solar battery module (20, 42, 52) of claim 1, further **characterized by**:
a buffer (30, 31) formed between the striped photoelectric transducing layer (26) and the striped transparent electrode (28), the buffer (30, 31) being made of zinc sulphide material and intrinsic zinc oxide material.

5. The see-through solar battery module (20, 42, 52) of claim 1, further **characterized in that** the striped metal electrode (24) is made of molybdenum material.

6. The see-through solar battery module (20, 42, 52) of claim 1, further **characterized in that** the striped photoelectric transducing layer (26) is made of copper indium gallium selenide material.

7. The see-through solar battery module (20, 42, 52) of claim 1, further **characterized in that** the striped transparent electrode (28) is a transparent conductive layer made of aluminum zinc oxide or tin-doped indium oxide material.

8. A method of manufacturing a see-through solar battery module (20, 42, 52) **characterized by**:
forming a metal electrode (23) on a transparent substrate (22);
removing parts of the metal electrode (23) along a first direction to form a plurality of striped metal electrodes (24) arranged in parallel;
forming a photoelectric transducing layer (25) on the plurality of striped metal electrodes (24) and the transparent substrate (22);
removing parts of the photoelectric transducing layer (25) along the first direction to form a plurality of striped photoelectric transducing layers (26) arranged in parallel, so as to expose parts of the transparent substrate (22) and parts of the plurality of striped metal electrode (24);
forming a transparent electrode (27) on the transparent substrate (22), the plurality of striped metal electrodes (24), and the plurality of striped photoelectric transducing layers (26); and
removing parts of the transparent electrode (27) along the first direction to form a plurality of striped transparent electrodes (28) arranged in parallel, so that the plurality of striped metal electrodes (24) and the plurality of striped transparent electrodes (28) are in series connection along a second direction different from the first direction.

9. The method of claim 8, further **characterized by**:
cleaning the transparent substrate (22) before forming the metal electrode (23) on the transparent substrate (22).

10. The method of claim 9, further **characterized by**:
forming a buffer (30, 31) between the photoelectric transducing layer (25) and the transparent electrode (27).

11. The method of claim 8, further **characterized by**:
removing the parts of the striped transparent electrode (28), the parts of the striped photoelectric transducing layer (26), and the parts of the striped metal electrode (24) along the second direction so as to expose parts of the transparent substrate (22).

12. The method of claim 8, further **characterized by**:
removing parts of the plurality of striped metal electrodes (24) along the second direction to form the plurality of block metal electrodes arranged as an array after removing the parts of the metal electrode (23) along the first direction to form the plurality of striped metal electrodes (24) arranged in parallel; and
removing parts of the plurality of striped photoelectric transducing layers (26) along the second direction to expose parts of the transparent substrate (22) after removing the parts of the photoelectric transducing layer (25) along the first direction to form the plurality of striped photoelectric transducing layers (26) arranged in parallel.

13. The method of claim 8, further **characterized in that** removing the parts of the metal electrode (23) along the first direction to form the plurality of striped metal electrodes (24) arranged in parallel comprises utilizing a laser to segment the metal electrode (23) into the plurality of striped metal electrodes (24) arranged in parallel.

14. The method of claim 8, further **characterized in that** removing the parts of the photoelectric transducing layer (25) along the first direction comprises utilizing a scraper to remove the parts of the photoelectric transducing layer (25) along the first direction.

15. The method of claim 9, further **characterized in that** removing the parts of the transparent electrode (27) along the first direction comprises removing the parts of the transparent electrode (27) and the parts of the photoelectric transducing layer (25) along the first direction simultaneously.
